# EUROPEAN PATENT SPECIFICATION

(11) **EP 2 843 913 B1**
(45) Date of publication and mention of the grant of the patent: **21.11.2018**
(21) Application number: 14182647.9
(22) Date of filing: 28.08.2014
(51) Int. Cl.: H04M 1/02, H01Q 1/24, H05K 1/18

(54) **Mounting structure for a flexible printed circuit board**
Montagestruktur für eine flexible Leiterplatte
Structure d'assemblage pour un circuit imprimé flexible

(30) Priority: 28.08.2013 KR 20130102740
(43) Date of publication of application: 04.03.2015
(73) Proprietor: Samsung Electronics Co., Ltd., Gyeonggi-do 443-742 (KR)
(72) Inventor: Park, Sung-Wu, Daegu (KR); Kim, Min-Suk, Gyeongsangbuk-do (KR); Park, Soon-Sang, Daegu (KR)
(74) Representative: Nederlandsch Octrooibureau

(56) References cited:
- US-A1- 2009 322 629
- US-A1- 2012 162 936
- US-A1- 2012 252 535
- US-B1- 6 770 813

## Description

### TECHNICAL FIELD

The present invention relates to a mounting structure for firmly mounting a flexible member on a mounting member.

### BACKGROUND

At present, owing to the growth of electronic communication industries, user devices such as mobile communication terminals (i.e., cellular phones), electronic schedulers, personal complex terminals, and the like are becoming necessities to modern society while being becoming significant means for delivery of fast changing information.

Recently, users prefer slim electronic devices being easy to carry around as well as providing a diversity of functions. This is leading the trend of efficiently mounting various components in a limited space.

US 6,770,813 B1 discloses a microelectronic package including a flexible substrate. The package is adapted to be installed on a support structure, and includes a frame that is affixed to a perimeter of a first portion of the flexible substrate.

US 2012/0162936 A1 discloses a mobile terminal having first and second casings that are connected. An electrically conductive plate is disposed in the first casing, the second casing or between the first and second casings, and a flexible printed circuit board connects the first and second casings. An electrically conductive reinforcement member is connected to a surface of a portion of the flexible printed circuit board. An electrically conductive connecting member conducts electricity between the electrically conductive reinforcement member and the electrically conductive plate.

US 2012/0252535 A1 discloses an electronic apparatus with a housing having an LCD display section mounted in the housing, a space section formed between an end side in the housing and the LCD display section, and a circuit unit having an antenna pattern, a microphone and one or more other mounting components.

### SUMMARY

The present disclosure has been made to address at least the above problems and disadvantage, and to provide at least the advantages described below. Accordingly, in an aspect of the present disclosure is to provide a structure for firmly mounting a flexible member (e.g., a flexible antenna) on a mounting member.

In accordance with the invention, there is provided a mounting structure according to appended claim 1. Preferable features of the invention are defined in the appended dependent claims.

Before undertaking the DETAILED DESCRIPTION below, it may be advantageous to set forth definitions of certain words and phrases used throughout this patent document: the terms "include" and "comprise," as well as derivatives thereof, mean inclusion without limitation; the term "or," is inclusive, meaning and/or; the phrases "associated with" and "associated therewith," as well as derivatives thereof, may mean to include, be included within, interconnect with, contain, be contained within, connect to or with, couple to or with, be communicable with, cooperate with, interleave, juxtapose, be proximate to, be bound to or with, have, have a property of, or the like; and the term "controller" means any device, system or part thereof that controls at least one operation, such a device may be implemented in hardware, firmware or software, or some combination of at least two of the same. It should be noted that the functionality associated with any particular controller may be centralized or distributed, whether locally or remotely. Definitions for certain words and phrases are provided throughout this patent document, those of ordinary skill in the art should understand that in many, if not most instances, such definitions apply to prior, as well as future uses of such defined words and phrases.

### BRIEF DESCRIPTION OF THE DRAWINGS

For a more complete understanding of the present disclosure and its advantages, reference is now made to the following description taken in conjunction with the accompanying drawings, in which like reference numerals represent like parts:
FIGS. 1 and 2 illustrate exploded perspective diagrams of a structure according to one exemplary of the present disclosure;
FIGS. 3 to 6 illustrate diagrams of a combination of members in a structure according to one exemplary embodiment of the present disclosure;
FIG. 7 illustrates a perspective diagram of a structure according to another exemplary embodiment of the present disclosure;
FIG. 8 illustrates a perspective diagram of a structure according to a further exemplary embodiment of the present disclosure;
FIG. 9 illustrates a perspective diagram of an electronic device according to various exemplary embodiments of the present disclosure;
FIGS. 10 and 11 illustrate perspective diagrams of a speaker and antenna structure according to various exemplary embodiments of the present disclosure;
FIG. 12 illustrates a perspective diagram of a combination state between a bracket and a PCB according to various exemplary embodiments of the present disclosure; and
FIG. 13 illustrates a graph of a resonance characteristic of when an FPCB antenna attaching a reinforcement plate is fixed to a carrier according to one exemplary embodiment of the present disclosure.

### DETAILED DESCRIPTION

The following description with reference to the accompanying drawings is provided to assist in a comprehensive understanding of embodiments of the disclosure as defined by the claims and their equivalents. It includes various specific details to assist in that understanding but these are to be regarded as merely examples. In addition, descriptions of well-known functions and constructions may be omitted for clarity and conciseness.

The terms and words used in the following description and claims are not limited to their dictionary meanings, but, are merely used to enable a clear and consistent understanding of the disclosure. Accordingly, it should be apparent to those skilled in the art that the following description of embodiments of the present disclosure is provided for illustration purposes only and not for the purpose of limiting the disclosure as defined by the appended claims and their equivalents.

It is to be understood that the singular forms "a," "an," and "the" include plural references as well, unless the context clearly dictates otherwise. Thus, for example, reference to "a component surface" includes reference to one or more of such surfaces.
By the term "substantially" it is meant that the recited characteristic, parameter, or value need not be achieved exactly, but that deviations or variations, including for example, tolerances, measurement error, measurement accuracy limitations and other factors known to those of skill in the art, may occur in amounts that do not preclude the effect the characteristic was intended to provide.

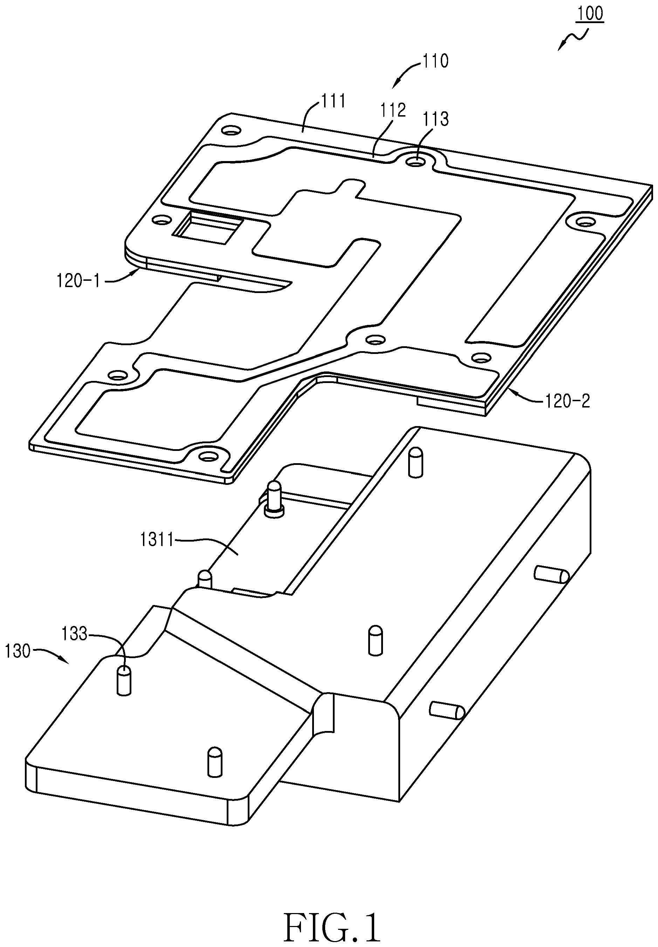

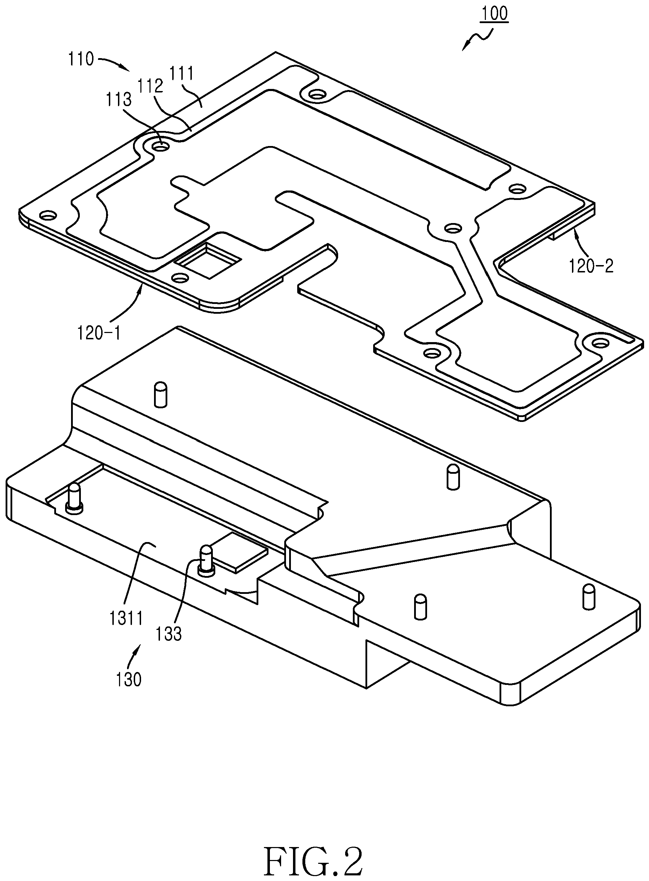

FIGS. 1 and 2 illustrate exploded perspective diagrams of a structure according to one exemplary of the present disclosure.

Referring to FIGS. 1 and 2, the structure (or combinations structure) 100 may include a flexible member 110, reinforcement members 120-1 and 120-2, and a mounting member 130.

The flexible member 110 may be mounted on the mounting member 130 in a deformed form adaptive to a shape of surface of the mounting member 130. The flexible member 110 may be of a film shape. For example, as illustrated, the flexible member 110 may be a Flexible Printed Circuit Board (FPCB). The FPCB 110 may include an insulation film (e.g., a polyimide film) 111, and a copper film 112 attached to the insulation film 111. The copper film 112 may have a predetermined pattern, and the FPCB 110 may be used as an antenna. The flexible member 110 may have a plurality of through-holes 113 which a plurality of fusion protrusion parts 133 of the mounting member 130 pass through. The plurality of through-holes 113 may be formed in a region in which the copper film 112 is disposed, and/or be formed even in other regions.

The reinforcement members 120-1 and 120-2 may be attached to the flexible member 110 through the medium of an adhesive means such as a double-sided tape, a bond and the like. The reinforcement members 120-1 and 120-2 may be surface-attached and adhered to the flexible member 110. Adhesive surfaces of the reinforcement members 120-1 and 120-2 may be of a shape inclusive of a planar surface and/or curved surface adaptive to a surface shape of the mounting member 130. The reinforcement members 120-1 and 120-2 may be of a shape capable of being fitly mounted adaptive to a mounting surface of the mounting member 130. For example, the reinforcement members 120-1 and 120-2 may be planar plates or curved plates. The reinforcement members 120-1 and 120-2 may stop the deformation of a corresponding portion of the flexible member 100. The reinforcement members 120-1 and 120-2 may have a degree of rigidity such that they withstand bending. The reinforcement members 120-1 and 120-2 may be formed of conductive materials or non-conductive materials. The reinforcement members 120-1 and 120-2 may be formed of epoxy resin, FR-4, Steel Use Stainless (SUS) or the like. When being mounted on the mounting member 130 in a deformed form, the flexible member 110 may show a portion that separates from the mounting member due to elasticity of the flexible member. The reinforcement member 120-1 may be disposed in such separable portion that may show separation from the mounting member, such as to prevent a phenomenon of separation of the flexible member 110 from the mounting member. For example, the reinforcement members 120-1 and 120-2 may be disposed around a curve part of the flexible member 110. The reinforcement members 120-1 and 120-2 may be extended to one side edge of the flexible member 110. The copper film 112 of the flexible member 110 may not be moved or deformed by virtue of the reinforcement members 120-1 and 120-2, and the antenna using the copper film 112 may secure its performance. The reinforcement members 120-1 and 120-2 may have a plurality of through-holes (not shown) which the plurality of fusion protrusion parts 133 of the mounting member 130 pass through. As illustrated, the reinforcement members 120-1 and 120-2 may be disposed between the flexible member 110 and the mounting member 130. The flexible member 110 may be disposed between the reinforcement members 120-1 and 120-2 and the mounting member 130 as well.

The mounting member 130 may mount the flexible member 110 attaching the reinforcement members 120-1 and 120-2. The mounting member 130 is used for fixing the flexible member 110 attaching the reinforcement members 120-1 and 120-2, and may have the plurality of fusion protrusion parts 133 protruding from the mounting surface of the mounting member 130. This mounting member 130 may be mounted in an electronic device. For example, the mounting member 130 may be at least a part of a housing that defines outer surface of the electronic device. The mounting member 130 may be also mounted on a Printed Circuit Board (PCB) of the electronic device or a main board thereof. The mounting member 130 may be of a shape capable of using a space between peripheral structures. The mounting surface of the mounting member 130 may have surfaces of various directions, surfaces of different areas, or surfaces of various forms (e.g., a planar surface and a curve surface). As described above, the flexible member 110 may be deformed in a form adaptive to the mounting surface of the mounting member 130 and be mounted on the mounting surface of the mounting member 130. The mounting member 130 may have a groove 1311 capable of fitly mounting the reinforcement member 120-1. The reinforcement member 120-1 may be fitly mounted in the groove 1311 of the mounting member 130, and be subjected to a limit of movement.

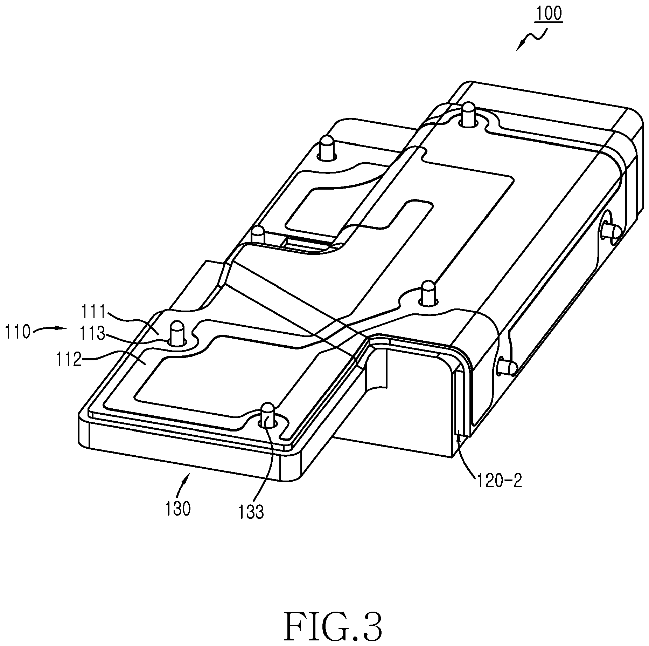

FIGS. 3 to 6 illustrate diagrams of a combination of members in a structure according to one exemplary embodiment of the present disclosure.

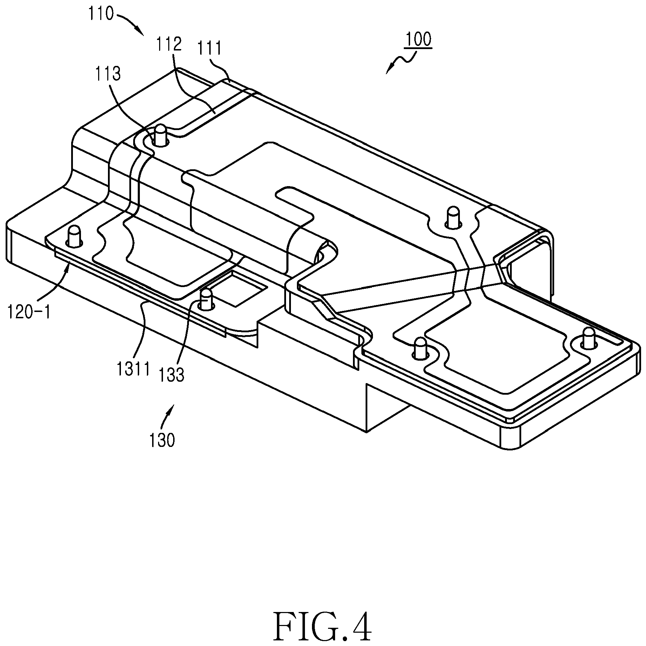

Referring to FIGS. 3 and 4, the flexible member 110 attaching the reinforcement members 120-1 and 120-2 may be deformed into a form adaptive to the mounting surface of the mounting member 130, and be fitly mounted on the mounting member 130. The reinforcement member 120-1 may be fitly mounted in the groove 1311 provided in the mounting member 130. The flexible member 110 and the reinforcement members 120-1 and 120-2 may be settled down by the plurality of fusion protrusion parts 133 of the mounting member 130. The plurality of fusion protrusion parts 133 of the mounting member 130 may pass through the plurality of through-holes 113 of the flexible member 110 and protrude from a surface of the flexible member 110. The plurality of fusion protrusion parts 133 of the mounting member 130 corresponding to the reinforcement members 120-1 and 120-2 may also pass through the reinforcement members 120-1 and 120-2.

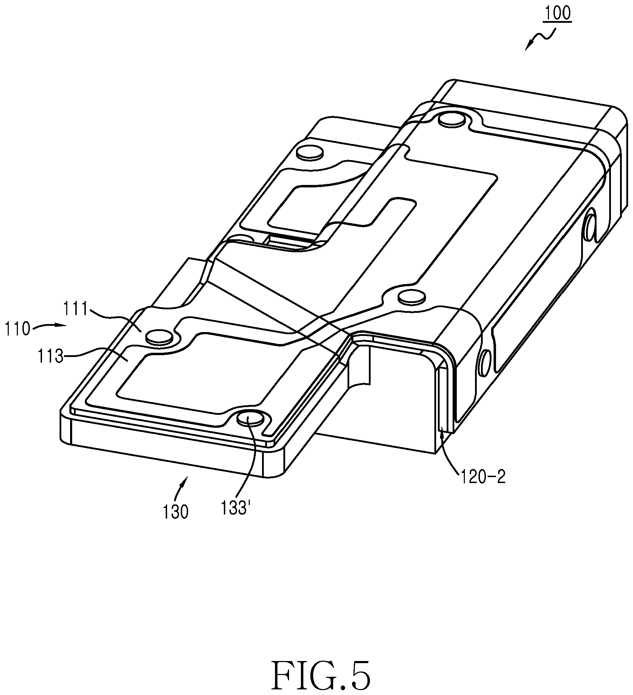

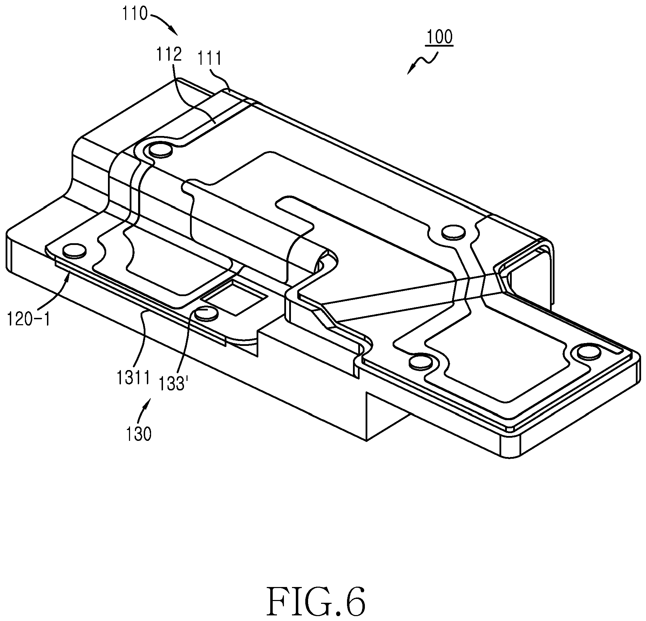

Referring to FIGS. 5 and 6, the plurality of fusion protrusion parts (133 illustrated in FIG. 4) of the mounting member 130 protruding from the surface of the flexible member 110 may be deformed and cured using a heat fusion method. Through this heat fusion method, a plurality of heat fusion parts 133' are created from the plurality of fusion protrusion parts 133 of the mounting member 130. The plurality of heat fusion parts 133' of the mounting member 130 may fix the flexible member 110 and the reinforcement members 120-1 and 120-2 to the mounting member 130. By means of the plurality of heat fusion parts 133', the flexible member 110 may keep its deformed form. However, portions of the flexible member 110 not corresponding with the plurality of heat fusion parts 133' of the mounting member 130 may show an escaping motion (e.g., separation) from the mounting surface of the mounting member 130 by elasticity of the flexible member. Portions of the flexible member 110 corresponding with the plurality of heat fusion parts 133' of the mounting member 130 might be cured into a non-uniform form with peripheral portions due to heat caused by heat fusion. This may also induce the phenomenon of separation, or simply lifting, of the flexible member 110 from the mounting member. Also in this case, the reinforcement members 120-1 and 120-2 may be disposed in a suitable place, stopping the phenomenon of separation of the flexible member 110 and tightly fixing the flexible member 110 to the mounting member 130. The reinforcement members 120-1 and 120-2 may be extended to one side edge of the flexible member 110 or be disposed at a curve part of the flexible member 110 or around the curve part to inhibit an unfolding restoration motion of at least a portion of the flexible member 110.

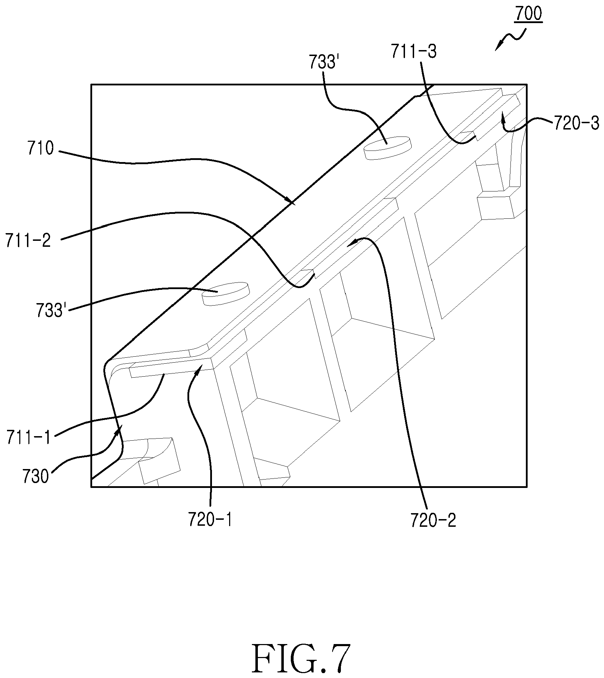

FIG. 7 illustrates a perspective diagram of a structure according to another exemplary embodiment of the present disclosure.

Referring to FIG. 7, the structure 700 may include a flexible film 710, reinforcement plates 720-1, 720-2, and 720-3, and a mounting member 730. The flexible film 710 may be mounted on the mounting member 730 in a deformed form adjusting to a shape of the surface of the mounting member 730. The segmented reinforcement plates 720-1, 720-2, and 720-3 are attached to one side extension part of the flexible film 710. This extension part of the flexible film 710 attaching the reinforcement plates 720-1, 720-2, and 720-3 may be fixed to a side surface of the mounting member 730. When the extension part of the flexible film 710 is fixed to the side surface of the mounting member 730, it may use a method of heat-fusing 733' fusion protrusion parts of the mounting member 730 to a surface of the flexible film 710. The reinforcement plates 720-1, 720-2, and 720-3 may be fitly mounted in grooves or recesses 711-1, 711-2, and 711-3 provided in the side surface of the mounting member 730 and may be subjected to a limit of movement. The reinforcement plates 720-1, 720-2, and 720-3 may stop a restoration motion of at least a portion of the flexible member 710.

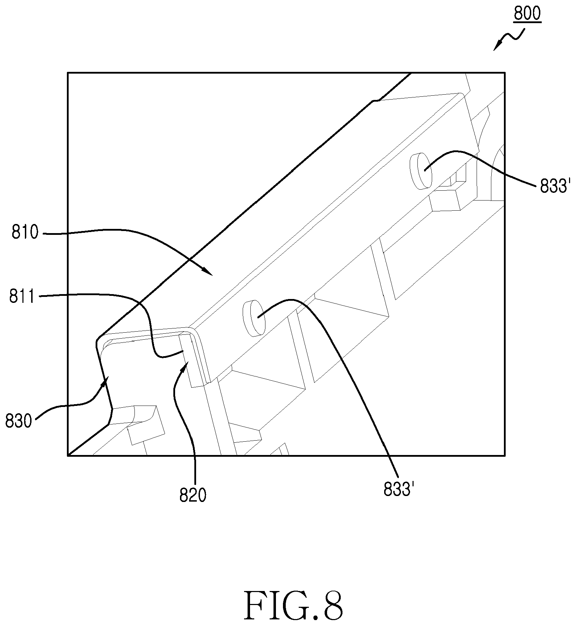

FIG. 8 illustrates a perspective diagram of a structure according to a further exemplary embodiment of the present disclosure.

Referring to FIG. 8, the structure 800 may include a flexible film 810, a reinforcement plate 820, and a mounting member 830. The flexible film 810 may be mounted on the mounting member 830 in a deformed form adaptive to a surface of the mounting member 830. According to one exemplary embodiment, the flexible film 810 may be bent and disposed on an upper surface of the mounting member 830, a lateral surface thereof, and a lower surface thereof. The reinforcement plate 820 is attached to one side extension part of the flexible film 810. This extension part of the flexible film 810 attaching the reinforcement plate 820 may be fixed to the lower surface of the mounting member 830. When the extension part of the flexible film 810 is fixed to the lower surface of the mounting member 830, it may use a method of heat-fusing 833' fusion protrusion parts of the mounting member 830 to a surface of the flexible film 810. The reinforcement plate 820 may be fitly mounted in a groove 811 provided in the lower surface of the mounting member 830 and may be subjected to a limit of movement. The reinforcement plate 820 may stop a restoration motion of at least a portion of the flexible member 810.

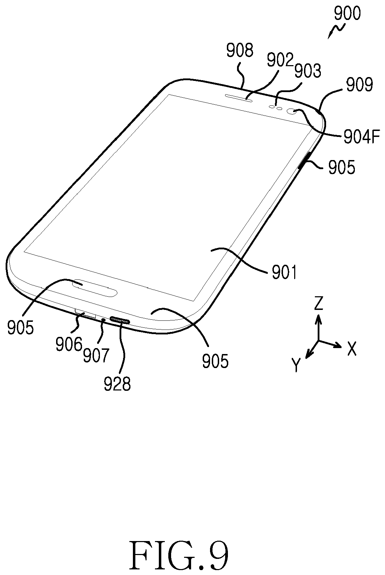

FIG. 9 illustrates a perspective diagram of an electronic device according to various exemplary embodiments of the present disclosure.

Referring to FIG. 9, the electronic device 900 may include a touch screen 901, a front speaker 902, a side speaker 928, at least one sensor 903, a front camera 904F, at least one key 905, an external port 906, a microphone 907, a jack 908, and an antenna 909.

The touch screen 901 may display a video, and receive a touch input. The touch screen 901 may include a display, a touch panel, and a pen sensor (e.g., a digitizer).

The front speaker 902 and/or the side speaker 928 may output an electric signal as a sound.

The at least one sensor 903 may meter a physical quantity or sense an operation state of the electronic device 900 to convert metered or sensed information into an electric signal. The at least one sensor 903 may be mounted in a specific position of the electronic device 900. The at least one sensor 903 may include at least one of a gesture sensor, a proximity sensor, a grip sensor, a gyro sensor, an acceleration sensor, a geomagnetic sensor, an air pressure sensor, a temperature/humidity sensor, a hall sensor, a Red, Green, Blue (RGB) sensor, a light sensor, a biological sensor, and a Ultraviolet (UV) sensor.

The camera 904F is a device capable of taking an image and a video, and may include one or more image sensors, Image Signal Processors (ISPs) (not shown), or flash Light Emitting Diodes (LEDs) (not shown).

The key 905 may include a press key or a touch key. The key 905 may include a key capable of adjusting a volume, or a key capable of powering on or off.

The external port 906 may be used as a High-Definition Multimedia Interface (HDMI), a Universal Serial Bus (USB), a projector, a D-subminiature (D-sub), or a charging port.

The microphone 907 may convert a sound into an electric signal.

The jack 908 may be electrically connected with plugs of an earphone, an ear set and the like.

The antenna 909 (e.g., a Digital Multimedia Broadcasting (DMB) antenna) may be taken and extracted outside the electronic device 900.

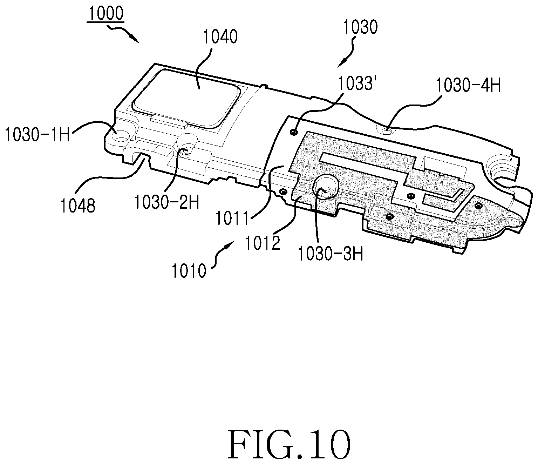

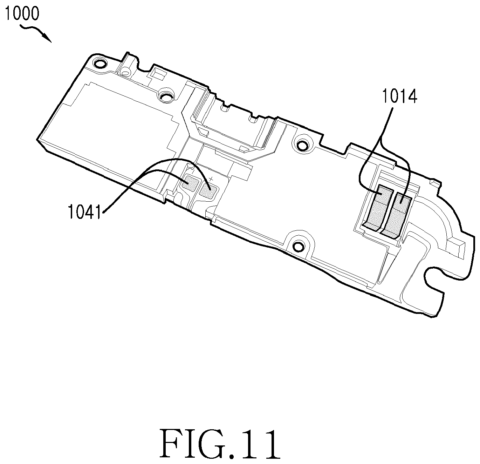

FIGS. 10 and 11 illustrate perspective diagrams of a speaker and antenna structure according to various exemplary embodiments of the present disclosure.

Referring to FIGS. 10 and 11, the speaker and antenna structure 1000 may include an FPCB antenna 1010, at least one reinforcement plate (not shown), a carrier 1030, and a speaker 1040.

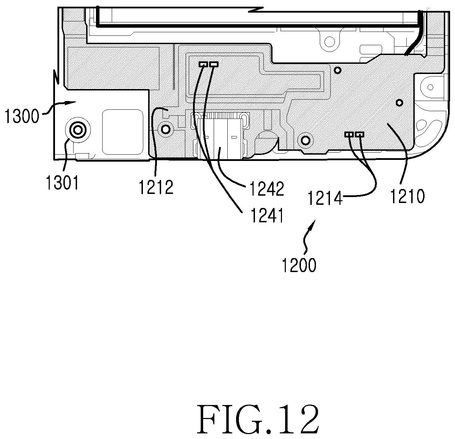

The FPCB antenna 1010 may include an insulation film (e.g., a polyimide film) 1011, and a copper film 1012 attached to the insulation film 1011. The copper film 1012 may have a predetermined pattern, and may be electrically connected to a PCB (e.g., a PCB 1200 of FIG. 12) of an electronic device (e.g., the electronic device 900 of FIG. 9) to transmit/receive a wireless signal. The FPCB antenna 1010 may be fixed to the carrier 1030 in a deformed (e.g., bent) form adaptive to a surface of the carrier 1030.

The at least one reinforcement plate (not shown) may be attached to the FPCB antenna 1010 through the medium of an adhesive means such as a double-sided tape, a bond, and the like. The at least one reinforcement plate may be surface contacted and adhered to the FPCB antenna 1010. The at least one reinforcement plate may be of a shape capable of being fitly mounted adaptive to a mounting surface of the carrier 1030. For example, the at least one reinforcement plate may be a planar plate or a curve plate. The at least one reinforcement plate may stop the deformation of a corresponding portion of the FPCB antenna 1010.

The carrier 1030 may mount the FPCB antenna 1010 attaching the at least one reinforcement plate. A plurality of fusion protrusion parts (not shown) of the carrier 1030 may be deformed and cured using a heat fusion method, after passing through the FPCB antenna 1010 attaching the at least one reinforcement plate. Through this heat fusion method, a plurality of heat fusion parts 1033' of the carrier 1030 are formed. The plurality of heat fusion parts 1033' of the carrier 1030 may play a role of fixing the FPCB antenna 1010 attaching the at least one reinforcement plate to the carrier 1030. The carrier 1030 may be a non-metallic injection mold. The carrier 1030 may be mounted on the PCB of the electronic device (e.g., the electronic device 900 of FIG. 9). Speaker terminals 1041 of the speaker 1040 may be disposed on a bottom surface of the carrier 1030. The carrier 1030 may have a hole 1048 for discharging a sound of the speaker 1040 to a side surface of the electronic device. Antenna terminals 1014 of the FPCB antenna 1010 may be disposed on the bottom surface of the carrier 1030. The speaker terminals 1041 of the speaker 1040 may be electrically connected with elastic terminals (e.g., C-clips) (1241 of FIG. 12) of the PCB of the electronic device. The antenna terminals 1014 of the FPCB antenna 1010 may be electrically connected with elastic terminals (e.g., C-clips) (1214 of FIG. 12) of the PCB of the electronic device. The antenna terminals 1014 of the FPCB antenna 1010 may include a feed terminal for feeding and a ground terminal for grounding. The FPCB antenna 1010 may be electrically connected to the PCB (1200 of FIG. 12) of the electronic device through the antenna terminals 1014 of the FPCB antenna 1010, and may be operated in an Inverted F Antenna (IFA) or Planar Inverted F Antenna (PIFA) method. For the sake of combination with a bracket (1300 of FIG. 12), the carrier 1030 may have through-holes 1030-2H, 1030-3H, and 1030-4H for bolt-coupling which a plurality of bolts may pass through. The carrier 1030 may have a boss through-hole 1030-1H which a boss (1301 of FIG. 12) of the bracket (1300 of FIG. 12) may pass through.

FIG. 12 illustrates a perspective diagram of a combination state between a bracket and a PCB according to various exemplary embodiments of the present disclosure.

The PCB 1200, a substrate on which a basic circuit and a plurality of electronic components are mounted, may set an execution environment of the electronic device (e.g., 900 of FIG. 9), and maintain information of the electronic device 900, and make the electronic device 900 stably driven, and make smooth a data input/output exchange of all devices of the electronic device 900. The PCB 1200 may be combined to the bracket 1300 through a coupling method of a bolt and the like.

The PCB 1200 may have a socket (e.g., the external port 906). Or, the PCB 1200 may have a ground 1212. Or, the PCB 1200 may have the elastic terminals 1241 electrically contactable with the speaker terminals (1041 of FIG. 11). Or, the PCB 1200 may have the elastic terminals 1214 electrically contactable with the antenna terminals (1014 of FIG. 11). The elastic terminals 1214 of the PCB 1200 may include a feed terminal for feeding and a ground terminal for grounding.

The bracket 1300 may be a mounting plate capable of mounting a plurality of electronic components. The bracket 1300 may be a frame capable of fixing and supporting the plurality of electronic components (e.g., a processor, a memory, a Subscriber Identification Module (SIM) card, an audio codec, a speaker, a receiver, a microphone, a camera module, an indicator, a motor, a power management module, a battery, a communication module, a user input module, a display module, an interface, a sensor module, and the like). For example, the bracket 1300 may mount a window, a touch panel, a display panel or a digitizer. Or, the PCB 1200 may be mounted on the bracket 1300. The bracket 1300 may be also combined to a housing forming an appearance of the electronic device (900 of FIG. 9).

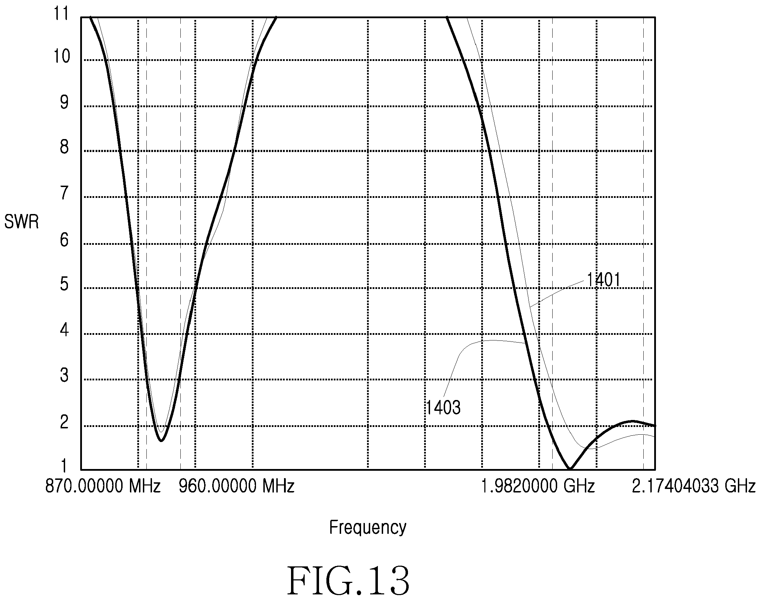

FIG. 13 illustrates a graph of a resonance characteristic of when an FPCB antenna attaching a reinforcement plate is fixed to a carrier according to one exemplary embodiment of the present disclosure.

As illustrated in FIG. 13, it may be appreciated that an antenna structure (e.g., 100 of FIG. 3) 1401 fixing to a carrier an FPCB antenna attaching at least one reinforcement plate has a relatively greater antenna performance than a structure 1403 not applying the reinforcement plate. As described above, the at least one reinforcement plate may stop the degradation of antenna performance by preventing a phenomenon of movement and separation of the FPCB antenna on the carrier.

In accordance with implementations of the present disclosure, a structure 100 may include a flexible member 110, at least one reinforcement member 120-1, 120-2 attached to the flexible member 110, and preventing the deformation of at least one portion of the flexible member 110, and a mounting member 130 for mounting the flexible member 110 attaching the at least one reinforcement member 120-1, 120-2.

In accordance with implementations of the present disclosure, the flexible member 110 may be mounted on the mounting member 130 in a deformed form adaptive to a surface of the mounting member 130.

In accordance with implementations of the present disclosure, the flexible member 110 may include a film.

In accordance with implementations of the present disclosure, the flexible member 110 may include a Flexible Printed Circuit Board (FPCB).

In accordance with implementations of the present disclosure, the flexible member 110 may include an antenna radiator.

In accordance with implementations of the present disclosure, the flexible member 110 may be disposed between the reinforcement member and the mounting member.

In accordance with implementations of the present disclosure, the at least one reinforcement member 120-1, 120-2 may be disposed between the flexible member 110 and the mounting member 130.

In accordance with implementations of the present disclosure, the at least one reinforcement member 120-1, 120-2 may be of a plate shape.

In accordance with implementations of the present disclosure, the at least one reinforcement member 120-1, 120-2 may be fitly mounted in at least one groove or recess 1311 of the mounting member.

In accordance with implementations of the present disclosure, the at least one reinforcement member 120-1, 120-2 may be extended to at least one side edge of the flexible member 110.

In accordance with implementations of the present disclosure, the at least one reinforcement member 120-1, 120-2 may be overlapped with a flexible metal comprised in the flexible member 110.

In accordance with implementations of the present disclosure, the flexible member 110 attaching the at least one reinforcement member 120-1, 120-2 has a plurality of through-holes 113. The mounting member 130 may include a heat fusion part 133' being heat-fused after passing through the plurality of through-holes 113 of the flexible member 110 and, if applicable, the reinforcement member(s).

In accordance with other implementations of the present disclosure, an electronic device 900 may include an FPCB antenna 1010 for transmitting/receiving a wireless signal, at least one reinforcement plate attached to the FPCB antenna 1010, and preventing the deformation of at least one portion of the FPCB antenna 1010, and a mounting member (e.g., a carrier 1030) for mounting the FPCB antenna 1010 attaching the at least one reinforcement plate.

In accordance with other implementations of the present disclosure, the FPCB antenna 1010 attaching the at least one reinforcement plate has a plurality of through-holes. The mounting member 1030 may include a heat fusion part 1033' being heat-fused after passing through the plurality of through-holes of the FPCB antenna 1010.

In accordance with other implementations of the present disclosure, the FPCB antenna 1010 attaching the at least one reinforcement plate may be mounted on the mounting member 1030 in a deformed form adaptive to a surface of the mounting member 1030.

In accordance with another implementation of the present disclosure, the at least one reinforcement plate may prevent the deformation of at least a portion of a copper film included in the FPCB antenna 1010.

In accordance with other implementations of the present disclosure, the at least one reinforcement plate may be fitly mounted in at least one groove 1311 of the mounting member 1030.

In accordance with other implementations of the present disclosure, the electronic device 900 further includes a main board (e.g., a PCB 1200) fixed to the mounting member, and the main board 1200 may be electrically connected with the FPCB antenna 1010 and process a wireless signal through the FPCB antenna 1010.

In accordance with other implementations of the present disclosure, the main board (e.g., the PCB 1200) may have terminals 1214 which are electrically elastic-contacted with the FPCB antenna 1010.

In accordance with other implementations of the present disclosure, the mounting member 1030 may include a housing forming an appearance of the electronic device 900.

As described above, the FPCB antenna may be firmly and tightly fixed to the mounting member and thus, the degradation of its performance may be prevented. Also, the FPCB antenna may be firmly fixed to the mounting member irrespective of a shape of the mounting member and thus, a pattern of the FPCB antenna may be designed freely.

## Claims

1. A mounting structure (700) for a portable device, the mounting structure comprising:
a mounting member (730) including a mounting surface and a plurality of heat fusion parts (133) protruded from the mounting surface;
a flexible printed circuit board, FPCB, (710) disposed on the mounting surface, wherein the FPCB (710) is bended in a form conforming to the mounting surface and includes a plurality of through-holes (113) corresponding with the heat fusion parts (133);
wherein the heat fusion parts (133) are heat-fused after penetrating the through-holes (113) for fixing the FPCB to the mounting member (730),
at least one rigid reinforcement plate (720-1, 720-2, 720-3) disposed between the mounting member (730) and the FPCB (710), wherein the at least one rigid reinforcement plate (720-1, 720-2, 720-3) is surface-attached to the FPCB (710), wherein the mounting surface comprises, at least one recess (711-1, 711-2, 711-3), and the least one rigid reinforcement plate (720-1, 720-2, 720-3) is fitted into the at least one recess (711-1, 711-2, 711-3), and
the at least one rigid reinforcement plate (720-1, 720-2, 720-3) is surface-attached to a portion of the FPCB (710) for preventing deformation of the portion of the FPCB.

2. The mounting structure of claim 1, wherein the FPCB (110) comprises an antenna radiator.

3. The mounting structure of claim 2, further comprises a Printed Circuit Board, PCB, coupled to the mounting member, wherein the antenna radiator is electrically connected to the PCB.

4. The mounting structure of claim 3, wherein the PCB is configured to process a signal via the antenna radiator.

5. The mounting structure of claim 1, wherein at least one reinforcement plate (720-1, 720-2, 720-3) is attached to a side edge of the FPCB (710).

6. The mounting structure of claim 1, wherein the mounting member includes a housing of an electronic device.

## Patentansprüche

1. Montagestruktur (700) für eine tragbare Vorrichtung, die Montagestruktur umfassend:
ein Montagebauteil (730), das eine Montagefläche und eine Vielzahl an Heißschmelzteilen (133), die von der Montagefläche hervorragen, enthält;
eine flexible Leiterplatte, FPCB, (710), die auf der Montagefläche angeordnet ist, wobei die FPCB (710) in eine Form gebogen ist, die sich der Montagefläche anpasst, und eine Vielzahl an Durchgangslöchern (113), entsprechend den Heißschmelzteilen (133), enthält;
wobei die Heißschmelzteile (133) nach einem Durchführen durch die Durchgangslöcher (113) zum Fixieren der FPCB am Montagebauteil (730) heißgeschmolzen werden,
zumindest eine starre Verstärkungsplatte (720-1, 720-2, 720-3), die zwischen dem Montagebauteil (730) und der FPCB (710) angeordnet ist, wobei die zumindest eine starre Verstärkungsplatte (720-1, 720-2, 720-3) an der FPCB (710) oberflächenbefestigt ist,
wobei die Montagefläche zumindest eine Vertiefung (711-1, 711-2, 711-3) umfasst und die zumindest eine starre Verstärkungsplatte (720-1, 720-2, 720-3) in die zumindest eine Vertiefung (711-1, 711-2, 711-3) eingesetzt ist und
die zumindest eine starre Verstärkungsplatte (720-1, 720-2, 720-3) an einem Abschnitt der FPCB (710) oberflächenbefestigt ist, um eine Verformung des Abschnitts der FPCB zu verhindern.

2. Montagestruktur nach Anspruch 1, wobei die FPCB (110) einen Antennenstrahler umfasst.

3. Montagestruktur nach Anspruch 2, die ferner eine Leiterplatte, PCB, umfasst, die an das Montagebauteil gekoppelt ist, wobei der Antennenstrahler elektrisch mit der PCB verbunden ist.

4. Montagestruktur nach Anspruch 3, wobei die PCB konfiguriert ist, ein Signal über den Antennenstrahler zu verarbeiten.

5. Montagestruktur nach Anspruch 1, wobei zumindest eine Verstärkungsplatte (720-1, 720-2, 720-3) an einer Seitenkante der FPCB (710) befestigt ist.

6. Montagestruktur nach Anspruch 1, wobei das Montagebauteil ein Gehäuse einer elektronischen Vorrichtung enthält.

## Revendications

1. Structure de montage (700) pour un dispositif portable, la structure de montage comprenant :
un organe de montage (730) comprenant une surface de montage et une pluralité de parties de fusion thermique (133) faisant saillie depuis la surface de montage ;
une carte de circuits imprimés souple, FPCB, (710) disposée sur la surface de montage, dans laquelle la FPCB (710) est pliée dans une forme conforme à la surface de montage et comprend une pluralité de trous traversants (113) correspondant aux parties de fusion thermique (133) ;
dans laquelle les parties de fusion thermique (133) sont fondues à la chaleur après pénétration dans les trous traversants (113) pour fixer la FPCB à l'organe de montage (730),
au moins une plaque de renfort rigide (720-1, 720-2, 720-3) disposée entre l'organe de montage (730) et la FPCB (710), dans laquelle l'au moins une plaque de renfort rigide (720-1, 720-2, 720-3) est attachée en surface à la FPCB (710),
dans laquelle la surface de montage comprend au moins un évidement (711-1, 711-2, 711-3) et l'au moins une plaque de renfort rigide (720-1, 720-2, 720-3) est ajustée dans l'au moins un évidement (711-1, 711-2, 711-3), et
l'au moins une plaque de renfort rigide (720-1, 720-2, 720-3) est attachée en surface à une portion de la FPCB (710) pour empêcher toute déformation de la portion de la FPCB.

2. Structure de montage selon la revendication 1, dans laquelle la FPCB (110) comprend un élément rayonnant d'antenne.

3. Structure de montage selon la revendication 2, comprenant en outre une carte de circuits imprimés, PCB, couplée à l'organe de montage, dans laquelle l'élément rayonnant d'antenne est relié électriquement à la PCB.

4. Structure de montage selon la revendication 3, dans laquelle la PCB est configurée pour traiter un signal par l'intermédiaire de l'élément rayonnant d'antenne.

5. Structure de montage selon la revendication 1, dans laquelle au moins une plaque de renfort (720-1, 720-2, 720-3) est attachée à un bord latéral de la FPCB (710).

6. Structure de montage selon la revendication 1, dans laquelle l'organe de montage comprend un boîtier d'un dispositif électronique.
